## Europäisches Patentamt
## European Patent Office
## Office européen des brevets

(11) Veröffentlichungsnummer: **0 471 229 A1**

# EUROPÄISCHE PATENTANMELDUNG

(21) Anmeldenummer: **91112639.9**

(51) Int. Cl.⁵: **C08L 81/02**, C08K 5/42

(22) Anmeldetag: **27.07.91**

(30) Priorität: **11.08.90 DE 4025561**

(43) Veröffentlichungstag der Anmeldung:
**19.02.92 Patentblatt 92/08**

(84) Benannte Vertragsstaaten:
**DE FR GB IT**

(71) Anmelder: **BAYER AG**

**W-5090 Leverkusen 1 Bayerwerk(DE)**

(72) Erfinder: **Köhler, Burkhard, Dr.**
**Mündelheimstrasse 94**
**W-4150 Krefeld 11(DE)**
Erfinder: **Reinking, Klaus, Dr.**
**Robert-Stolz-Strasse 16 b**
**W-5632 Wermelkirchen(DE)**

(54) **Mischungen aus modifizierten Polyarylensulfiden und Polycarbonaten.**

(57) Die Erfindung betrifft Mischungen aus modifizierten Polyarylensulfiden (PAS), vorzugsweise Polyphenylensulfiden (PPS) mit Polycarbonaten.

EP 0 471 229 A1

Die Erfindung betrifft Mischungen aus modifizierten Polyarylensulfiden (PAS), vorzugsweise Polyphenylensulfiden (PPS) mit Polycarbonaten.

Mischungen verschiedener Thermoplasten sollen synergistisch die positiven Eigenschaften beider Komponenten vereinen. Während eine völlige Mischbarkeit der Komponenten oft nur zu einer arithmetischen Mittlung der Eigenschaften führt, zeigen zweiphasige Mischungen oft unzureichende mechanische Eigenschaften.

Angestrebt werden zweiphasige Mischungen, die einen gewissen Übergang beider Phasen aufweisen (Ankopplung).

Mischungen von PAS mit Polycarbonaten können folgende positiven Eigenschaften gegenüber unmodifiziertem PAS aufweisen;

1) verbesserte Zähigkeit (Polycarbonat des 2,2-Bis-(4-hydroxyphenyl)-propans(BPA),

2) konstanter Modul bei höheren Temperaturen (amorphe Poly(ester)carbonate aus Tere- und Isophthalsäureestergruppen, Carbonatestergruppen und Bisphenolen, z.B. BPA, oder 1,1-Bis(4-hydroxylphenyl)-cyclohexan (BPZ), 1,1-Bis(4-hydroxyphenyl)-3,3,5-trimethyl-cyclohexan (HIP-BP)),

3) hohe Steifigkeit (Polyestercarbonate, die eine flüssigkristalline Schmelze aufweisen).

Die Ankopplung von PAS an Carbonatestergruppen-haltige Polymere ist oft ungenügend, so daß keine synergistischen Effekte auftreten.

Es wurde nun gefunden, daß Mischungen aus modifizierten PAS (vorzugsweise modifiziertem PPS) mit Carbonatestergruppen-haltigen Polymeren (vorzugsweise aromatischen Polycarbonaten) verbesserte mechanische Eigenschaften aufweisen.

Gegenstand der Erfindung sind daher

Mischungen aus

A) 1 - 99 Gew.-%, vorzugsweise 10 - 90 Gew.-% modifizierten Polyarylensulfiden, die durch Schmelzmischung von 100 Teilen PAS, vorzugsweise 100 Teilen PPS mit 0,1 - 10 Teilen, vorzugsweise 0,5 - 3 Teilen von sulfogruppenhaltigen Phenolen der Formel (I)

$$(HO)_n\text{-Ar-}(SO_3H)_m \qquad (I),$$

wobei

n und m für 1 oder 2, vorzugsweise für 1 stehen und Ar für einen (n + m)-valenten aromatischen Rest mit 6 - 14 Kohlenstoffatomen, vorzugsweise für einen Naphthylenrest, steht, hergestellt wurden,

B) 1 - 99 Gew.-%, vorzugsweise 10 - 90 Gew.-% Carbonatestergruppen-haltigen Polymeren und

C) bezogen auf die Summe (A + B) 0 - 300 Gew.-% Glasfasern und/oder mineralischen Füllstoffen.

Beispiele für die Komponente B sind Polycarbonate des BPA, des BPZ und des HIP-BP, amorphe Polyestercarbonate aus Iso- und/oder Terephthalsäureestergruppen, Carbonatestergruppen und Bisphenolen, in der Schmelze flüssigkristalline Polyestercarbonate enthaltend Estergruppen der Kohlensäure, der Iso- und/oder Terephthalsäure, der 4-Hydroxylbenzoesäure und Hydrochinon und/oder 4,4'-Di-hydroxybiphenyl als Bisphenole.

Polycarbonate sind kommerziell erhältlich (z.B. Makrolon® der Fa. Bayer).

Die Komponenten A werden beispielsweise durch Extrusion von PPS (z.B. TEDUR®) auf dem Doppelwellenextruder ZSK 32 der Fa. Werner und Pfleiderer bei 320°C mit 4-Sulfophenol, 1-Hydroxynaphthalinsulfonsäure-2, 1-Hydroxynaphthalinsulfonsäure-4, 2-Hydroxy-naphthalinsulfonsäure-1, 2-Hydroxy-naphthalinsulfonsäure-3, vorzugsweise den Naphthalinverbindungen, hergestellt.

Die Sulfophenole und -naphthole sind handelsüblich.

Als mineralische Füll- und Verstärkungsstoffe seien z.B. Glasfasern, Glaskugeln, Glimmer, Talkum, Quarzmehl, Metaloxide und -sulfide, z.B. $TiO_2$, ZnS, Graphit, Ruß, Fasern aus Quarz oder Kohlenstoff, Carbonate, z.B. $MgCO_3$, $CaCO_3$ oder Sulfate wie z.B. $CaSO_4$, $BaSO_4$, genannt.

Die erfindungsgemäßen Mischungen können auf übliche Weise durch Extrusion hergestellt werden.

Als weitere übliche Zusatzstoffe können Pigmente, Entformungsmittel, E-Wachse, Fließhilfsmittel, Nucleiierungsmittel oder Stabilisatoren eingesetzt werden.

Die erfindungsgemäßen Mischungen können auf übliche Weise zu Formteilen, Halbzeug, Leiterplatten, Fasern, Folien, Profilen usw. verarbeitet werden.

Beispiele

Die Schmelzmischung wurde bei 320°C mit dem Doppel wellenextruder ZSK 32 durchgeführt. Das verwendete PPS wurde nach EP 171 021 hergestellt.

Vergleichsbeispiel 1

Gemischt wurden 60 Gew.-% PPS der Schmelzviskosität 40 Pas (310° C, 1000 s⁻¹) und 40 Gew.-% Makrolon® 2808 (BPA-Polycarbonat, Bayer).

Vergleichsbeispiel 2

Gemischt wurden 40 Gew.-% PPS, 40 Gew.-% CS 7916® (Glasfaser mit Aminosilanhaftvermittler, Bayer) und 20 Gew.-% Makrolon® 2808.

Synthesebeispiel (modifiziertes PPS)

Gemischt wurden 98 Gew.-% PPS mit 2 Gew.-% 1-Hydroxy-2-naphthalinsulfonsäure.

Beispiel 1

Gemischt wurden 60 Gew.-% modifiziertes PPS und 40 Gew.-% Makrolon® 2808.

Beispiel 2

Gemischt wurden 40 Gew.-% modifiziertes PPS, 40 Gew.-% CS 7916® und 20 Gew.-% Makrolon® 2808.

Folgende Tabelle faßt die Ergebnisse zusammen:

|  | Biegefestigk. (MPa) | Randfaser-dehnung (%) | Biege-modul (MPa) | Izod-Schlagzähigk. $a_n$ (kJ/m$^2$) |
|---|---|---|---|---|
| Vergl. 1 | 102 | 3,7 | 3075 | 13,6 |
| 1 | 116 | 5,4 | 3026 | 15,4 |
| Vergl. 2 | 206 | 1,9 | 11024 | 21,3 |
| 2 | 239 | 2,1 | 11795 | 26,2 |

Die Mischungen aus erfindungsgemäß modifizierten PPS und Polycarbonat weisen bessere Zähigkeitawerte und Biegefestigkeiten im Vergleich zu den Mischungen mit unmodifizierten PPS auf.

**Patentansprüche**

1. Mischungen aus
   A) 1 - 99 Gew.-% modifizierten Polyarylensulfiden, die durch Schmelzmischung von 100 Teilen PAS, mit 0,1 - 10 Teilen von sulfogruppenhaltigen Phenolen der Formel (I)

   $(HO)_2$-Ar-$(SO_3H)_m$     (I),

   wobei
   n und m für 1 oder 2 und Ar für einen (n + m)-valenten aromatischen Rest mit 6 - 14 Kohlenstoffatomen steht, hergestellt wurden,
   B) 1 - 99 Gew.-% Carbonatestergruppen-haltigen Polymeren und
   C) bezogen auf die Summe (A + B) 0 - 300 Gew.-% mineralischen Füllstoffen.

2. Verwendung der Mischungen nach Anspruch 1 zur Herstellung geformter Körper.

| | EINSCHLÄGIGE DOKUMENTE | | EP 91112639.9 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int Cl⁴) |
| A | <u>DE - A - 3 534 946</u><br>(BAYER AG)<br>    * Beispiele; Ansprüche *<br>        -- | 1,2 | C 08 L 81/02<br>C 08 K  5/42 |
| A | <u>DE - A - 3 900 260</u><br>(BAYER AG)<br>    * Beispiele; Ansprüche *<br>        ---- | 1,2 | |
| | | | RECHERCHIERTE SACHGEBIETE (Int Cl⁴) |
| | | | C 08 L 81/00<br>C 08 K |
| | Der vorliegende Recherchenbericht wurde für alle Patentansprüche erstellt. | | |

| Recherchenort | Abschlußdatum der Recherche | Prüfer |
|---|---|---|
| WIEN | 28-11-1991 | TENGLER |